# EUROPEAN PATENT APPLICATION

(11) **EP 2 179 798 A1**
(43) Date of publication of application: **28.04.2010**
(21) Application number: 09173649.6
(22) Date of filing: 21.10.2009
(51) Int. Cl.: B05D 5/06, B05D 7/04

(54) **Device housing and method for manufacturing the same**

(30) Priority: 27.10.2008 CN 200810305237
(71) Applicant: FIH (Hong Kong) Limited, Cheng Sha Wan Kowloon Hong Kong (CN)
(72) Inventor: Chiang, Chwan-Hwa, 231, Taipiei Hsien (TW); Chen, Jeng-Shiung, 231, Taipei Hsien (TW)
(74) Representative: Craven, Ian

(57) **Abstract**

A device housing and a method of fabricating the device housing are provided. The device housing includes a base housing, a bottom coating, a pattern layer, a middle coating and a top coating. The bottom coating is directly formed on the base housing. The pattern layer is a vacuum evaporation coating and directly formed on the bottom coating. The middle coating is of a degree of transparency and directly formed on the pattern layer. The transparent top coating is directly formed on the middle coating.

## Description

The present disclosure relates to a device housing and a method for manufacturing the device housing.

Electronic devices such as mobile phones usually fabricate their housings with decorative sprayed paints. The painted exterior surface of the housing is then printed with patterns layers. However, the printed pattern layer may be boring and cannot present a graceful metallic appearance. Further, due to being exposed to the outside, the pattern layers tend to be worn or eroded, which may degrade the aesthetic appearance of the housing.

Therefore, there is room for improvement within the art.

### BRIEF DESCRIPTION OF THE DRAWING

Many aspects of the new device housing and a method for manufacturing the device housing can be better understood with reference to the following drawings. The components in the drawings are not necessarily drawn to scale, the emphasis instead being placed upon clearly illustrating the principles of the new device housing and a method for manufacturing the device housing. Moreover, in the drawings, like reference numerals designate corresponding parts throughout the several views.

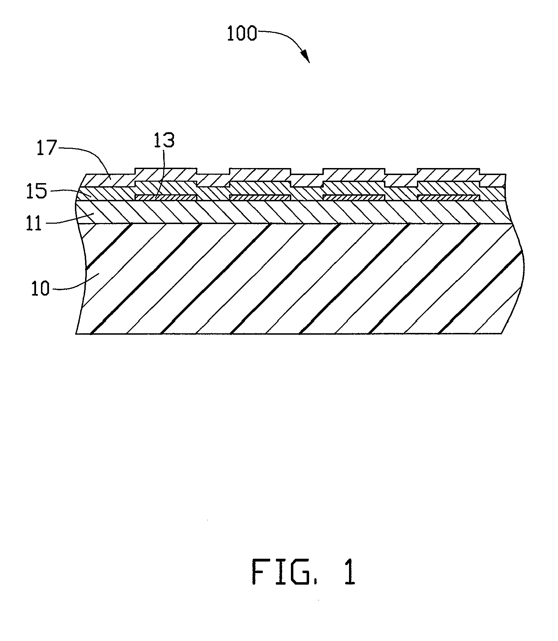

FIG. 1 is a cross section of an exemplary device housing as disclosed.

### DETAILED DESCRIPTION

FIG. 1 shows an exemplary device housing 100 including a base housing 10, a bottom coating 11 directly formed on the base housing 10, a pattern layer 13 directly formed on the bottom coating 11, a middle coating 15 directly formed on the pattern layer 13 and the bottom coating 11, and a top coating 17 directly formed on the middle coating 15.

The base housing 10 can be a plastic housing molded from one or more plastics selected from a group consisting of polyethylene (PE), polyamide (PA), polycarbonate (PC), acrylonitrile-butadiene-styrene (ABS), polymethyl methacrylate (PMMA) and polyethylene terephthalate (PET). Alternatively, the base housing 10 can be a metallic housing.

The bottom coating 11 is an ultraviolet (UV) coating. The UV coating may contain a preformed polymer of acrylic polyurethane and a UV initiator.

The pattern layer 13 is a vacuum evaporation coating. The target for the process of vacuum evaporation can be a metallic material selected from a group consisting of indium (In), tin (Sn), aluminum (Al), stainless steel, chromium (Cr), silicon (Si), and silicon dioxide (SiO₂). The pattern layer 13 is ranged from about 30-100 nm in thickness. The bottom coating 11 bonds well with the pattern layer 13, and further enhances the grace appearance of the pattern layer 13.

The middle coating 15 has a degree of transparency and made of a UV paint, a polyurethane paint or an unsaturated polyester paint. The middle coating 15 bonds well with the pattern layer 13.

The top coating 17 is transparent and made of a UV paint, a polyurethane paint or an unsaturated polyester paint. The top coating 17 has a high rigidity to provide a good protection for the exterior surface of the device housing 100 from, for example, wear and tear.

A method for manufacturing the device housing 100 as described may include the following steps.

The base housing 10 is provided. The bottom coating 11 is sprayed onto the exterior surface of the base housing 10.

The pattern layer 13 is vacuum evaporated onto the exterior surface of the bottom coating 11. During this step, an opaque cover housing with hollowed portions covers the bottom coating 11 of the base housing 10. The hollowed portions correspond to the pattern layer 13 in shape and size. The cover housing and the base housing 10 are vacuum evaporated to form the pattern layer 13 through the hollowed portions on the bottom coating 11. After completing of the vacuum evaporation, the cover housing is removed.

The middle coating 15 is sprayed on the pattern layer 13, and the top coating 17 is sprayed on the middle coating 15. It can be understood that the preformed device housing 100 may be cleaned to remove dust before spraying of the bottom coating 11, the middle coating 15 and the top coating 17.

It is to be understood, however, that even through numerous characteristics and advantages of exemplary embodiments have been set forth in the foregoing description, together with details of the structure and function of the embodiments, the disclosure is illustrative only, and changes may be made in detail, especially in matters of shape, size, and arrangement of parts within the principles of the disclosure to the full extent indicated by the broad general meaning of the terms in which the appended claims are expressed.

## Claims

1. A device housing, comprising:
a base housing;
a bottom coating directly formed on the base housing;
a pattern layer being a vacuum evaporation coating and directly formed on the bottom coating;
a middle coating having a degree of transparency directly formed on the pattern layer; and
a transparent top coating directly formed on the middle coating.

2. The device housing as claimed in claim 1, wherein the pattern layer is made of a metallic material selected from a group consisting of indium (In), tin (Sn), aluminum (Al), stainless steel, chromium (Cr), silicon (Si), and silicon dioxide (SiO₂).

3. The device housing as claimed in claim 1, wherein the pattern layer has a thickness of about 30-100 nm.

4. The device housing as claimed in claim 1, wherein the middle coating is located between the top coating and the pattern layer.

5. The device housing as claimed in claim 4, wherein the middle coating is made of a UV paint, a polyurethane paint or an unsaturated polyester paint.

6. The device housing as claimed in claim 4, wherein the top coating is made of a UV paint, a polyurethane paint or an unsaturated polyester paint.

7. The device housing as claimed in claim 1, wherein the bottom coating contains a UV paint.

8. The device housing as claimed in claim 1, wherein the base housing is molded from one or more plastics selected from a group consisting of made of a plastic material selected from a group consisting of Polyethylene (PE), polyamide (PA), polycarbonate (PC), acrylonitrile-butadiene-styrene (ABS), polymethyl methacrylate (PMMA) and polyethylene terephthalate (PET)

9. The device housing as claimed in claim 1, wherein the base housing is a metal housing.

10. A manufacturing method for device housing, comprising:
providing a base housing ;
forming a bottom coating on the surface of the base housing;
vacuum evaporating a pattern layer on the surface of the bottom coating;
forming a middle coating, having a degree of transparency, on the surface of the pattern layer; and
forming a transparent top coating on the surface of the middle coating.

11. The device housing as claimed in claim 10, wherein the bottom coating is sprayed UV paint.

12. The manufacturing method for device housing as claimed in claim 10, wherein a target for the vacuum evaporation of the pattern layer is a metallic material selected from a group consisting of indium (In), tin (Sn), aluminum (Al), stainless steel, chromium (Cr), silicon (Si), and silicon dioxide (SiO₂).

13. The manufacturing method for device housing as claimed in claim 10, wherein the vacuum evaporated pattern layer has a thickness of about 30-100 nm.

14. The manufacturing method for device housing as claimed in claim 10, wherein the middle coating is located between the top coating and the pattern layer.

15. The manufacturing method for device housing as claimed in claim 14, wherein the middle coating is sprayed UV paint, a polyurethane paint or an unsaturated polyester paint.

16. The manufacturing method for device housing as claimed in claim 10, wherein the top coating is spayed UV paint, a polyurethane paint or an unsaturated polyester paint.
